# EUROPEAN PATENT SPECIFICATION

(11) **EP 0 704 969 B1**
(45) Date of publication and mention of the grant of the patent: **28.10.1998**
(21) Application number: 95115289.1
(22) Date of filing: 28.09.1995
(51) Int. Cl.: H03K 3/03

(54) **Astable multivibrators**
Astabile Multivibratoren
Multivibrateurs astables

(30) Priority: 29.09.1994 KR 9424755; 13.10.1994 KR 9426194; 16.12.1994 KR 9434590
(43) Date of publication of application: 03.04.1996
(73) Proprietor: Samsung Electronics Co., Ltd., Suwon-city, Kyungki-do 441-370 (KR)
(72) Inventor: Kim, Won-Kyum, Suwon-City, Kyungki-do (KR); Won, Jang-Sik, Dobong-gu, Seoul (KR)
(74) Representative: Tunstall, Christopher Stephen

(56) References cited:
- EP-A- 0 450 750
- US-A- 3 851 277
- US-A- 4 301 427
- US-A- 4 414 515

## Description

The present invention relates to high frequency oscillators, and more particularly to astable multivibrators.

Generally, astable multivibrators have been used as oscillators in 4 bit or 8 bit micro-computers and as portable timekeeping devices. In many applications such as, for example, the driving oscillator in DC-DC converter circuits, it is desirable to generate relatively high frequencies. For applications as subscriber loop carrier systems in which cost, size and power consumption of the converter are of particular importance, it is also desirable to fabricate such oscillators in integrated circuit form. Present technology, however, dictates that integrated oscillators be of the resistance-capacitance type since inductive elements cannot be fabricated in integrated form.

In a conventional astable multivibrator, the operating frequency thereof is determined by resistors R and capacitors C, and most of the capacitors have fixed capacitance value. In this case, if the capacitance is too small, the frequency oscillation can be distorted due to the effect of parasitic capacitance. Thus, the capacitor should be fabricated in a size capable of minimizing the effect of parasitic capacitance. If the capacitor is fabricated in a larger size in order to increase the capacitance thereof, this may cause an increase in power consumption.

As described above, an integrated RC oscillator has a problem of deteriorating high frequency oscillation performance due to the effect of the parasitic capacitance generated within the integrated circuit as well as a small feedback resistance to an input part.

Recently, CMOS (Complementary Metal Oxide Semiconductor) circuits have been widely employed in astable multivibrators. These CMOS circuits have a wide operating voltage and temperature range and a low temperature coefficient of threshold voltage. This makes them ideal for multivibrators.

Figure 1 of the accompanying diagrammatic drawings shows a circuit construction of a conventional astable multivibrator.

Figure 2 is a circuit diagram of another design of astable multivibrator.

Figure 3 is a detailed circuit diagram of Figure 2.

Figure 4 is a voltage waveform diagram illustrating operation of the multivibrator of Figure 2 as compared with that of Figure 1.

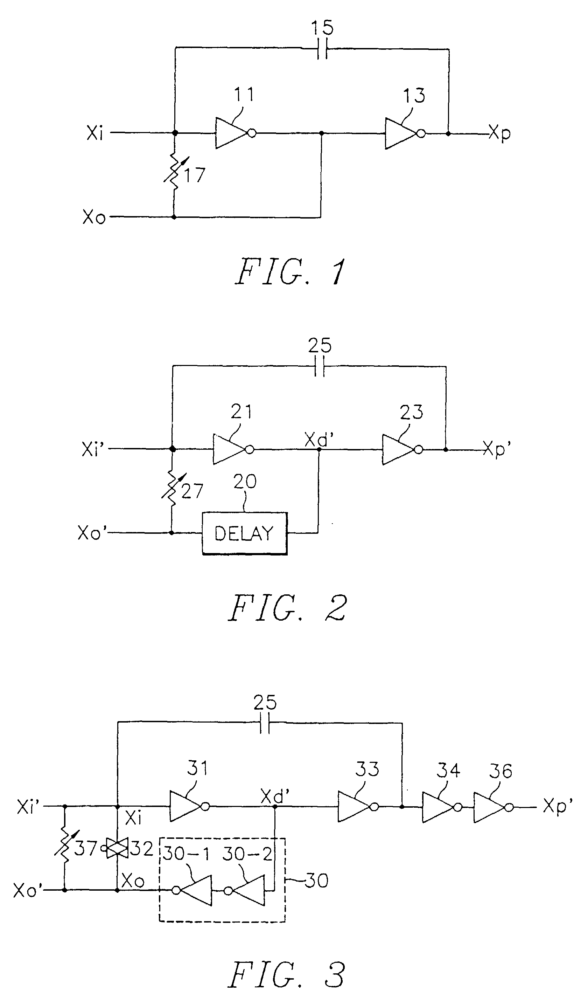

As shown in Figure 1, a variable resistor 17 is connected between an input signal Xi and a feedback signal Xo, and the input signal Xi is connected to an output signal Xp through first and second inverters 11 and 13. In addition, a capacitor 15 is connected between the input and output signals Xi and Xp, and the output of the first inverter 11 (or the input of the second inverter 13) is coupled to the feedback signal Xo.

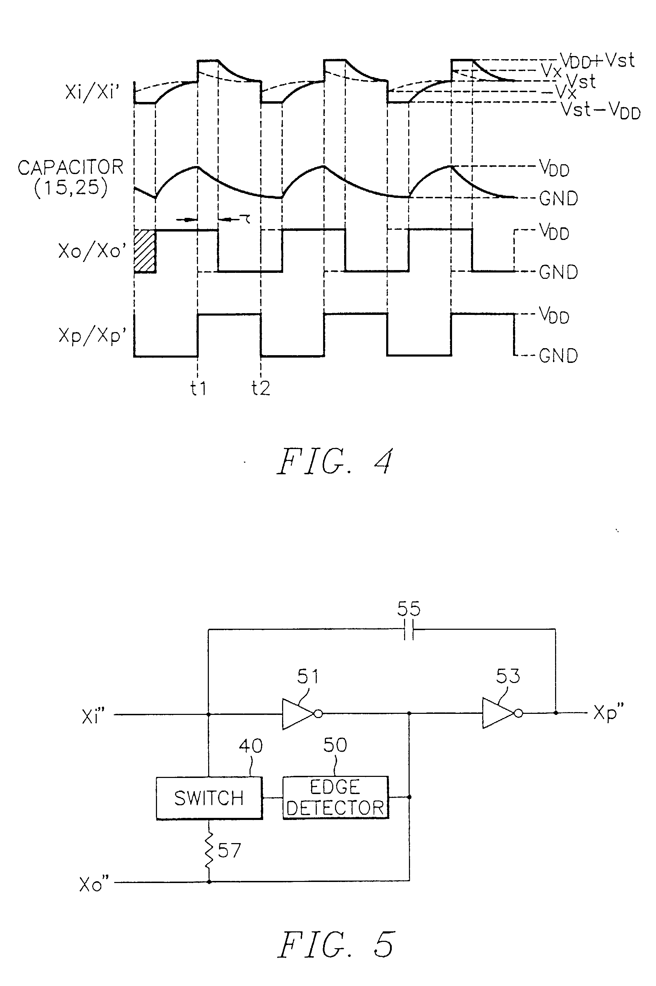

The operations of the conventional astable multivibrator of Figure 1 can be understood through the waveforms in Figure 4, where a waveform indicated by a dotted line is separated from that of Figure 2.

When a supply voltage is applied to the circuit, the feedback signal Xo has a CMOS logic level opposite to those of the input and output signals Xi and Xp. If the CMOS logic level is higher than the switching threshold voltage Vst of the first inverter 11, it goes to a logic "high" level, and otherwise, it goes to a logic "low" level. The first and second inverters 11 and 13 serve as amplifiers, and the voltage of the input signal Xi increases by the feedback signal Xo. When the voltage of the input signal Xi goes to higher than the switching threshold voltage Vst of the first inverter 11 at time tl, the output voltage of the first inverter 11 goes to the logic "low" level and the output voltage of the second inverter 13 goes to the logic "high" level. Thus, at time tl, the feedback and output signals Xo and Xp have logic "low" and "high" levels, respectively. At this time, the voltage level of the input signal Xi is rapidly increased by the feedback operation of the capacitor 15 until the output signal Xp reaches the power supply voltage level VDD, and such a feedback operation is repeated for a few nanoseconds.

After the output signal Xp reaches the power supply voltage level VDD, as the feedback signal Xo is in the logic "low" level, the voltage of the input signal Xi begins to be decreased through the variable resistor 17. If the voltage of the input signal Xi drops below the switching threshold voltage Vst of the first inverter 11, the output voltage of the first inverter 11 goes to the logic "high" level, and the output voltage of the second inverter 13 goes to the logic "low" level. Consequentially, the voltage of the input signal Xi is affected by the output signal Xp of logic "low" level through the capacitor 15 and is thereby lowered much more. At this time, the feedback signal Xo of logic "high" level increases the voltage of the input signal Xi through the variable resistor 17 from the time t2.

The variable resistor 17 serves as a factor determining how fast the input signal Xi which is affected by the voltage level of the feedback signal Xo swings from the logic "high" level to the logic "low" level or from the logic "low" level to the logic "high" level. That is, the variable resistor 17 determines the charge-discharge time of the capacitor 15, and consequentially becomes the factor for specifying the high frequency oscillation cycle of the vibrator. In order to obtain a faster input signal Xi with high frequency, the resistance value of the variable resistor 17 should be small within a predetermined range. In addition, the input signal Xi should have a desirable voltage operating range VDD + Vst to Vst - VDD.

However, as indicated by the dotted line in the waveform of the input signal Xi of Figure 4, if the resistance value of the variable resistor 17 is low, the charge or discharge operation to the capacitor 15 begins at Vx or -Vx, i.e. before the input signal Xi reaches VDD + Vst or Vst - Vdd. That is, the input signal Xi does not have the voltage operating range of VDD + Vst ∼ Vst -VDD. On the contrary, in the case of making the resistance value of the variable resistor 17 sufficiently high, there occurs a problem of deteriorating the high frequency oscillation performance, while improving the above problem of narrow voltage operating range.

US patent no. 3851277 describes a high frequency multivibrator in which three inverters are serially coupled to one another. Each inverter consists of a pair of complementary MOS transistors coupled in series between ground potential and a negative power supply voltage. A timing circuit includes a capacitor connected across the first two inverters and a resistor connected across all three inverters.

Referring to Figure 2, which shows another construction of multivibrator, a variable resistor 27 is connected between an input signal Xi' and a feedback signal Xo'. First and second inverters 21 and 23 are serially connected between the input signal Xi' and an output signal Xp', and a capacitor 25 is connected between the input and output signals Xi' and Xp' and in parallel with the first and second inverters 21 and 23. A CMOS type capacitor is employed herein for the capacitor 25. A delay 20 for delaying an output signal Xd' of the first inverter 21 for a predetermined time τ is connected between the output of the first inverter 21 and the feedback signal Xo'. The delay 20 can be fabricated by serially connecting even numbers of inverters corresponding to the required delay time τ.

The circuit can also be implemented by using a CMOS transmission gate 32 used as an internal resistor between the input and feedback signals Xi' and Xo' as shown in Figure 3. As the length of the transmission gate is much larger than the width thereof, the transmission gate 32 has a negligible resistance value. In addition, buffers 34 and 36 coupled to a node connected to the output of the second inverter 33 and to the capacitor 35 can also be employed for shaping the output signal Xp'.

Operation of an astable multivibrator according to Figure 2 will now be described with reference to Figure 4.

If the supply voltage is applied to the circuit, the input, feedback and output signals Xi', Xo' and Xp' respectively maintain logic "low", "high" and "low" levels at the beginning of the application. In this case, the feedback signal Xo' goes to the logic "high" level after the lapse of the delay time τ from the application of the supply voltage.

The voltage of the input signal Xi' begins to increase by the feedback signal Xo' of logic "high" level. If the voltage of the input signal Xi' increases above the switching threshold voltage Vst of the first inverter 21 or 31, the output signal Xd' of the first inverter 21 or 31 goes to logic "low" level and the output voltage of the second inverter 23 or 33, that is, the voltage of the output signal Xp' goes to logic "high" level. The output signal Xd' of logic "low" level is time-delayed by τ through the delay 20 or 30, and then is output as the feedback signal Xo'. That is, as shown in the waveform of Figure 4, right after the lapse of the delay time τ from the time tl, the feedback signal Xo' goes to the logic "low" level. Thus, during this delay time τ, the voltage of the input signal Xi' acceleratedly increases to the level of VDD + Vst in response to the increase of the voltage level of the output signal Xp' (whereas the voltage of the input signal Xi begins to drop before reaching the level of VDD + Vst in the circuit of Figure 1).

The voltage of the input signal Xi' begins to drop with the transition of the feedback signal Xo' to the logic "low" level. If the voltage of the input signal Xi' decreases below the switching threshold voltage Vst of the first inverter 21 or 31, the output signal Xd' of the first inverter 21 or 31 goes to logic "high" level and the output signal Xp' goes to logic "low" level. As aforementioned, the feedback signal Xo' goes to the logic "high" level after the lapse of the delay time τ from the time t2. Thus, during this delay time τ, the voltage of the input signal Xi' acceleratedly decreases to the level of Vst - VDD in response to the voltage drop of the output signal Xp'.

As described above, the delay time τ ensures that the high frequency input signal Xi' has a voltage operating range of VDD + Vst ∼ Vst - VDD, thus solving the problem of the conventional circuit of Figure 1 that the input signal Xi cannot have a wide voltage operating range required in a normal operation. Therefore, it is possible to ensure a desired voltage operating range even though the resistance value of the resistor 27 or 37 is set as to as low a value as possible, so as to make the high frequency oscillation cycle faster.

Referring to the following Table 1 comparing the result of a simulation of the multivibrator of Figure 1 with that of Figure 3, for example, in the case that a resistance value of 1.4KΩ is used under the condition of 25°C, the input signal Xi in the conventional circuit has a voltage of 3.799V (corresponds to the Vx level in the waveform of Figure 4) and a frequency of 31.7MHz, whereas the input signal Xi' in Figure 3 has a voltage of 5.637V (corresponds to the VDD + Vst level) and a frequency of 35.9MHz. Furthermore, in the case that the resistance value of the variable resistor is below 1.1KΩ, there occurs no vibration in the conventional circuit, whereas the input signal Xi' in Figure 3 has a voltage and frequency as shown in Table 1.

**Table 1**

| | | 100 KΩ | 50 KΩ | 10 KΩ | 4 KΩ | 2 KΩ | 1.7 KΩ | 1.4 KΩ | 1.1 KΩ | 0 KΩ |
|---|---|---|---|---|---|---|---|---|---|---|
| Figure I (prior art) | Xi[V] | 5.637 | 5.635 | 5.618 | 5.322 | 4.490 | 4.189 | 3.799 | No Vibration | No Vibration |
| | [MHz] | 1.6 | 3.0 | 11.4 | 21.7 | 29.7 | 31.5 | 31.7 | No vibration | No Vibration |
| Figure 3 (invention) | Xi'[V] | 5.646 | 5.644 | 5.642 | 5.640 | 5.639 | 5.638 | 5.637 | 5.635 | 5.595 |
| | [MHz] | 1.7 | 3.1 | 11.6 | 21.7 | 31.2 | 33.3 | 35.9 | 38.5 | 53.0 |

Preferred embodiments of the present invention aim to provide an improved astable multivibrator capable of generating a high frequency output signal having a stable and wide voltage operating range even though the resistance value determining the charge-discharge time of a capacitor is small.

According to one aspect of the present invention, there is provided a multivibrator comprising:
a plurality of amplification means (51,53) serially connected between an input signal node and an output signal node;
capacitor means (55) connected in parallel with the plurality of amplification means (51,53); and
resistor means (57) disposed between the input signal node and a feedback signal node to which a feedback signal Xo" logic-converted from the input signal node is supplied;
**characterized by** edge detection means (50) for detecting an edge of the feedback signal Xo"; and
switching means (40) for switching the connection of the resistor means (57) in response to an output signal of the edge detection means (50) to isolate the path between the input signal node and the feedback node for a predetermined time after detection of an edge of the feedback signal Xo".

Preferably, the output of one of the amplification means (51) is connected to the feedback signal node.

Preferably, the plurality of amplification means comprises a first inverter (51) having an input terminal connected to the input signal node, and a second inverter (53) having input and output terminals connected between an output terminal of the first inverter and the output signal node.

Preferably, the edge detection means comprises square wave generation means (70-1) for shaping the output signal of the first inverter (61) into a square wave, a delay means (70-2 to 70-4) for delaying the output signal of the first inverter (61) for a predetermined time, and NAND and NOR gates (70-5, 70-6) for receiving the output signals of the square wave generation means (70-1) and the delay means (70-2 to 70-4).

Preferably, the delay means (70-2 to 70-4) comprises an odd number of inverters.

Preferably, the square wave generation means (70-1) comprises at least one inverter.

Preferably, the switching means (60) comprises a plurality of transmission gates (60A-2 to 60B-2) serially connected to one another, each composed of an NMOS transistor and a PMOS transistor.

For a better understanding of the invention, and to show how embodiments of the same may be carried into effect, reference will now be made, by way of example, to Figures 5 to 9 of the accompanying diagrammatic drawings, in which:
Figure 5 is a circuit diagram illustrating an example of an astable multivibrator according to a preferred embodiment of the present invention;

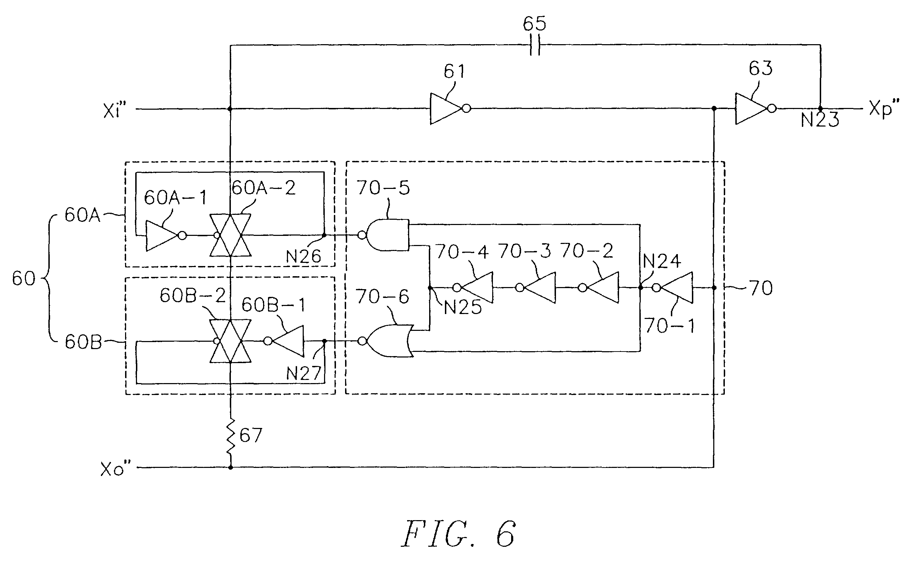

Figure 6 is a detailed circuit diagram of Figure 5;

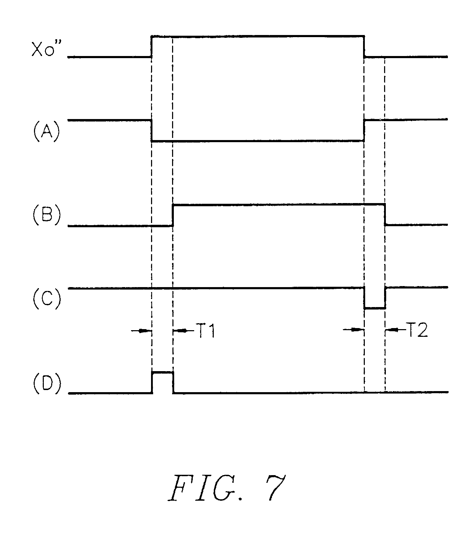

Figure 7 is a voltage waveform diagram of each node in an edge detector of Figure 6;

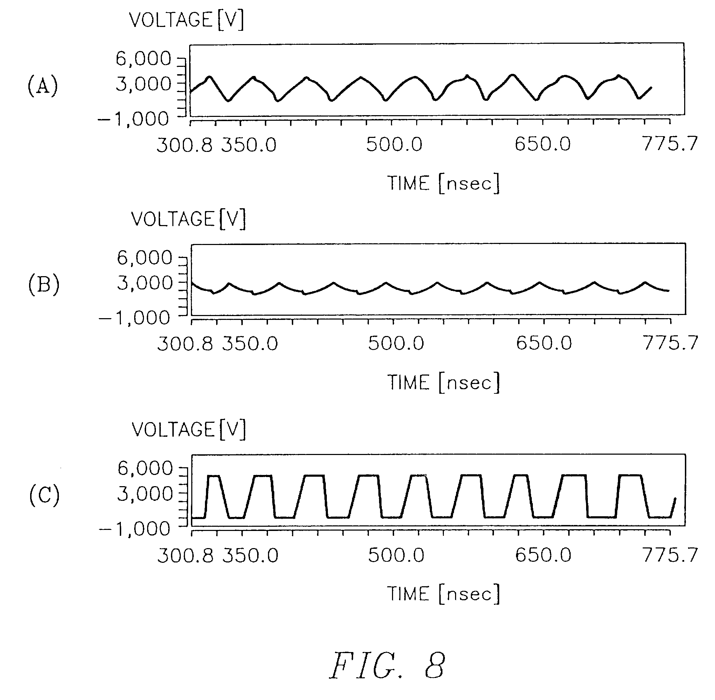

Figure 8 is a voltage waveform diagram according to the result of a simulation using a conventional circuit; and

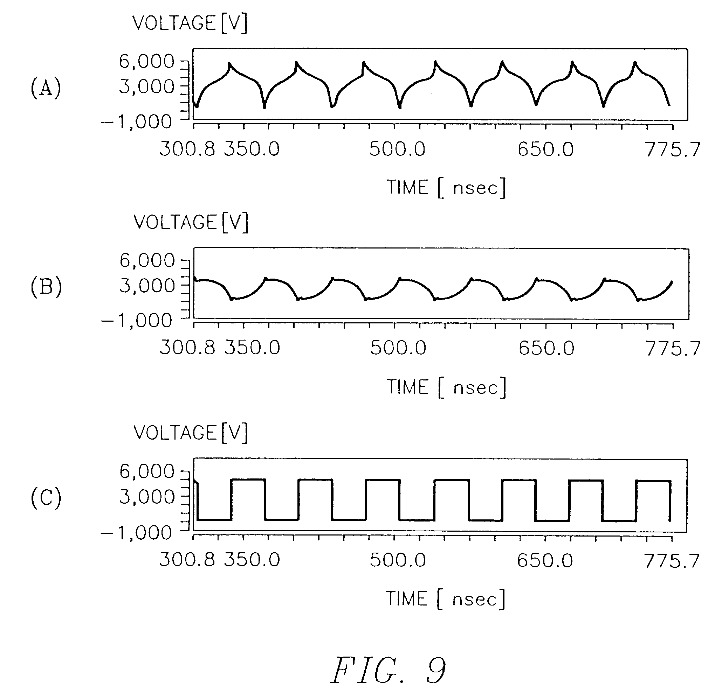

Figure 9 is a voltage waveform diagram according to the result of a simulation using an example of the present invention.

Figure 5 is a circuit diagram showing an astable multivibrator according to another embodiment of the present invention, and Figure 6 is an example of a detailed circuit diagram of Figure 5. Figure 7 shows a voltage waveform diagram of each node in the edge detector of Figure 5.

Referring more particularly to Figure 5, the astable multivibrator according comprises a pair of inverting amplifiers 51 and 53 connected between an input signal Xi'' and an output signal Xp", a capacitor 55 connected between the input and output signals Xi'' and Xp" and in parallel with the amplifiers 51 and 53, an edge detector 50 connected to a feedback signal Xo", for detecting the variation of the voltage level of the feedback signal Xo' which has passed through the amplifier 51, a resistor 57 connected between the input and feedback signals Xi'' and Xo'', and a switch 40 connected between the input signal Xi'' and the resistor 57, for switching the connection state therebetween in response to the output signal of the edge detector 50.

In Figure 6, first and second inverters 61 and 63 are serially connected between a first signal node and a third signal node, and a capacitor 65 is connected in parallel with the first and second inverters 61 and 63. An edge detector 70 detects the first and second edge pulses of a feedback signal Xo'' output from a connection node between the first and second inverters 61 and 63. A resistor 67 is connected to an input node of the edge detector 70 at its one end. A switch 60 is connected between the first signal node and the other end of the resistor 67, for isolating the path therebetween during the reception of the first and second edge detection pulses from the edge detector 70.

The edge detector 70 comprises a square wave generator composed of a third inverter 70-1, delay means composed of fourth, fifth and sixth inverters 70-2, 70-3 and 70-4 serially connected to one another for delaying the output of the square wave generator for a predetermined time, and a NAND gate 70-5 for NANDing the output of the third inverter 70-1 and the output of the delay means and then outputting the first edge detection pulse, i.e. the rising edge pulse, and a NOR gate 70-6 for NORing the output of the third inverter 70-1 and the output of the delay means and then outputting the second edge detection pulse, i.e. the falling edge pulse.

The switch 60 comprises first and second transmission gates 60A and 60B to be switched on respectively responsive to the first and second edge detection pulses output from the NAND gate 70-5 and the NOR gate 70-6. In the figure, 60A-2 and 60B-2 are typical transmission gates, each composed of an NMOS transistor and a PMOS transistor, and 60A-1 and 60B-1 are inverters for inverting the first and second edge detection pulses and driving the control electrodes of the PMOS transistors in the transmission gates 60A-2 and 60B-2.

Referring to Figure 7, the operation of opening/isolating the connection between the input signal Xi'' and the resistor 67 in response to the output of the edge detector 70 will now be described. If the feedback signal Xo'' is applied to the third inverter 70-1, the inverted signal is output to a node N24, shown as A in Figure 7. The signal thus obtained is inverted and delayed for a predetermined time T1 through the fourth, fifth and sixth inverters 70-2, 70-3 and 70-4, shown as B in Figure 7, and then is output to a node N25. The outputs of the nodes N24 and N25 are commonly applied to the NAND gate 70-5 and NOR gate 70-6, and the signals shown as C and D of Figure 7 are then output to the nodes N26 and N27.

The NMOS gate electrode of the first transmission gate 60A is coupled to the output line of the NAND gate 70-5 and the PMOS gate electrode thereof to the output of the NAND gate 70-5 through a seventh inverter 60A-1, whereby the first transmission gate 60A is turned on when the output signal of the NAND gate 70-5 is at a logic "high" level. The NMOS gate electrode of the second transmission gate 60B is coupled to the output of the NOR gate 70-6 through an eighth inverter 60B-1 and the PMOS gate electrode thereof to the output line of the NOR gate 70-6, whereby the second transmission gate 60B is turned on when the output signal of the NOR gate 70-6 is at a logic "low" level. During the delay time T1, the transmission gate 60B is turned off, and during the delay time T2, the first transmission gate 60A is turned off. Thus, the effect of the resistance value of the resistor 67 which is to be fed back to the input signal Xi'' is eliminated. Therefore, the input signal swings sufficiently to the logic "high" level or to the logic "low" level, outputting the output signal Xp" of high frequency with correct cycle.

In the case that the input signal Xi'' changes from a logic "high" level to a logic "low" level, such a change is detected by the edge detector 70. The effect of the feedback resistance from the first inverter 61 to the input signal Xi'' is isolated by the switch 60, whereby the feedback signal Xo'' passed through the first inverter 61 goes to logic "high" level and the output signal Xp" goes to logic "low" level. This results from the sufficient amplification by the first and second inverters 61 and 63. With the transition of the output signal Xp" to the logic "low" level, the input signal Xi" drops to the logic "low" level through the capacitor 65. Through the first and second inverters 61 and 63, the input signal Xi" of logic "low" level affects the output signal Xp" to be dropped much more to the logic "low" level. Such a step will be repeated until the output signal Xp" becomes 0V. After the output signal Xp" becomes 0V, the input signal Xi" remains at logic "low" level while the switch 60 is turned off by the edge detector 70. After the lapse of a predetermined delay time by the edge detector 70, the switch 60 is turned on, and the capacitor 65 is charged by the feedback current passed through the resistor 67 in response to the level variation of the feedback signal Xo'' which has passed through the first inverter 61. The moment the input signal Xi" exceeds the switching threshold voltage Vst, the edge detector 70 detects the level variation of the feedback signal Xo'' which has passed through the first inverter 61, and the switch 60 is thereby turned off. At this time, the input signal Xi" becomes higher than the switching threshold voltage by the first inverter 61, switch 60 and edge detector 70.

Such a small variation of the input signal Xi" is amplified through the first and second inverters 61 and 63 and affects the output signal Xp". By this variation of the output signal Xp", the input signal Xi" is varied again through the capacitor 65 by as much as the variation of the output signal Xp". Such an operation is repeated until the output signal Xp" reaches the VDD level. After the output signal Xp" reaches the VDD level, the input signal Xi" maintains the logic "high" level for the time delayed by the edge detector 70. In addition, after the lapse of a predetermined delay time by the edge detector 70, the switch 60 is turned on again, and the step of discharging the potential of the input signal Xi" from the capacitor 65 is repeated.

Figure 8 is a voltage waveform diagram according to the result of a simulation using a conventional circuit. In the figure, A, B and C show the waveforms of the input, feedback and output signals Xi, Xo, and Xp, respectively. As can be seen from the figure, the input signal Xi cannot have sufficient amplitude by the effect of the feedback resistance from the feedback signal Xo, resulting in the generation of a high frequency waveform with incorrect cycle. Figure 9 is a voltage waveform diagram according to the result of such a simulation using an example of the present invention. In Figure 9, A, B and C show the waveforms of the input, feedback and output signals Xi", Xo", and Xp", respectively. As compared to Figure 8, the input signal Xi" has sufficient amplitude by being isolated from the effect of the feedback resistance from the output signal of the first inverter, resulting in the generation of a high frequency waveform with correct cycle.

The major advantage of an astable multivibrator according to the present invention is the ability to enhance the high frequency oscillation performance and to generate high frequency output signals with a desired voltage operating range. In addition, it is possible to obtain high frequency output waveforms with correct cycles by excluding the effect of the feedback current, thus enhancing the oscillation performance and reliability of the astable multivibrator.

## Claims

1. A multivibrator comprising:
a plurality of amplification means (51,53) serially connected between an input signal node and an output signal node;
capacitor means (55) connected in parallel with the plurality of amplification means (51,53); and
resistor means (57) disposed between the input signal node and a feedback signal node to which a feedback signal Xo" logic-converted from the input signal node is supplied;
**characterized by** edge detection means (50) for detecting an edge of the feedback signal Xo"; and
switching means (40) for switching the connection of the resistor means (57) in response to an output signal of the edge detection means (50) to isolate the path between the input signal node and the feedback node for a predetermined time after detection of an edge of the feedback signal Xo".

2. A multivibrator according to claim 1, wherein the output of one of the amplification means (51) is connected to the feedback signal node.

3. A multivibrator according to claim 1 or claim 2, wherein the plurality of amplification means comprises a first inverter (51) having an input terminal connected to the input signal node, and a second inverter (53) having input and output terminals connected between an output terminal of the first inverter and the output signal node.

4. A multivibrator according to claim 3, wherein the edge detection means comprises square wave generation means (70-1) for shaping the output signal of the first inverter (61) into a square wave, a delay means (70-2 to 70-4) for delaying the output signal of the first inverter (61) for a predetermined time, and NAND and NOR gates (70-5, 70-6) for receiving the output signals of the square wave generation means (70-1) and the delay means (70-2 to 70-4).

5. A multivibrator according to claim 4, wherein the delay means (70-2 to 70-4) comprises an odd number of inverters.

6. A multivibrator according to claim 4 or 5, wherein the square wave generation means (70-1) comprises at least one inverter.

7. A multivibrator according to any preceding claim, wherein the switching means (60) comprises a plurality of transmission gates (60A-2 to 60B-2) serially connected to one another, each composed of an NMOS transistor and a PMOS transistor.

## Patentansprüche

1. Multivibrator mit:
einer Vielzahl von Verstärkungseinrichtungen (51, 53), welche in Reihe zwischen einen Eingangssignalknoten und einen Ausgangssignalknoten geschaltet sind;
einer Kapazitätseinrichtung (55), welche parallel zu der Vielzahl von Verstärkungseinrichtungen (51, 53) geschaltet ist; und
einer Widerstandseinrichtung (57), welche zwischen dem Eingangssignalknoten und einem Rückkoppelsignalknoten angeordnet ist, dem ein von dem Eingangssignalknoten logisch umgeformtes Rückkoppelsignal Xo" zugeführt wird;
**gekennzeichnet durch**
eine Flankenerfassungseinrichtung (50) zum Erfassen einer Flanke des Rückkoppelsignals Xo"; und
eine Schalteinrichtung (40) zum Schalten der Verbindung der Widerstandseinrichtung (57) als Reaktion auf ein Ausgangssignal der Flankenerfassungseinrichtung (50), um den Strompfad zwischen dem Eingangssignalknoten und dem Rückkoppelknoten für eine vorbestimmte Zeit nach der Erfassung einer Flanke des Rückkoppelsignals Xo" zu unterbrechen.

2. Mulitvibrator nach Anspruch 1, worin der Ausgang von einer der Verstärkungseinrichtungen (51) an den Rückkoppelsignalknoten angeschlossen ist.

3. Multivibrator nach Anspruch 1 oder 2, worin die Vielzahl der Verstärkungseinrichtungen einen ersten Inverter (51), welcher einen an den Eingangssignalknoten angeschlossenen Eingangsanschluß besitzt, und einen zweiten Inverter (53), der zwischen den Ausgangsanschluß des ersten Inverters und den Ausgangssignalknoten angeschlossene Eingangs- und Ausgangsanschlüsse besitzt, aufweist.

4. Multivibrator nach Anspruch 3, worin die Flankenerfassungseinrichtung eine Rechteckimpulssignalgeneratoreinrichtung (70-1) zum Umformen des Ausgangssignals des ersten Inverters (61) in ein Rechteckimpulssignal, eine Verzögerungseinrichtung (70-2 bis 70-4) zum Verzögern des Ausgangssignals des ersten Inverters (61) um eine vorbestimmte Zeit, und NAND und NOR Gatter (70-5, 70-6) zum Empfangen der Ausgangssignale der Rechteckimpulssignalgeneratoreinrichtung (70-1) und der Verzögerungseinrichtung (70-2 bis 70-4) aufweist.

5. Multivibrator nach Anspruch 4, worin die Verzögerungseinrichtung (70-2 bis 70-4) eine ungerade Anzahl von Invertern aufweist.

6. Multivibrator nach Anspruch 4 oder 5, worin die Rechteckimpulssignalgeneratoreinrichtung (70-1) wenigstens einen Inverter aufweist.

7. Multivibrator nach einem der vorangegangenen Ansprüche, worin die Schalteinrichtung (60) eine Vielzahl von Sendegattern (60A-2 bis 60B-2) aufweist, welche miteinander in Reihe geschaltet sind, wobei jedes Gatter aus einem NMOS-Transistor und einem PMOS-Transistor besteht.

## Revendications

1. Multivibrateur comprenant :
• une pluralité de moyens d'amplification (51, 53) branchés en série entre un noeud de signal d'entrée et un noeud de signal de sortie ;
• des moyens de condensateur (55) branchés en parallèle avec la pluralité de moyens d'amplification (51, 53) ; et
• des moyens de résistance (57) montés entre le noeud de signal d'entrée et un noeud de signal de rétroaction auquel on fournit un signal de rétroaction Xo" ayant subi une conversion logique, à partir du noeud de signal d'entrée ;
caractérisé par
• des moyens de détection de bord ou de flanc (50) pour détecter un bord du signal de rétroaction Xo" ; et
• des moyens de commutation (40) pour commuter la connexion des moyens de résistance (57) en réponse à un signal de sortie des moyens de détection de bord (50), de manière à isoler le chemin entre le noeud de signal d'entrée et le noeud de signal de rétroaction pendant un temps prédéterminé après la détection d'un bord du signal de rétroaction Xo".

2. Multivibrateur selon la revendication 1,
dans lequel
la sortie de l'un des moyens d'amplification (51) est connectée au noeud de signal de rétroaction.

3. Multivibrateur selon la revendication 1 ou la revendication 2,
dans lequel
la pluralité de moyens d'amplification comprend un premier inverseur (51) muni d'une borne d'entrée connectée au noeud de signal d'entrée, et un second inverseur (53) muni d'une borne d'entrée et d'une borne de sortie branchées entre une borne de sortie du premier inverseur et le noeud de signal de sortie.

4. Multivibrateur selon la revendication 3,
dans lequel
les moyens de détection de bord comprennent des moyens de génération d'ondes carrés (70-1) pour mettre en forme le signal de sortie du premier inverseur (61) de manière à lui donner une forme d'onde carrée, des moyens de retard (70-2 à 70-4) pour retarder d'une durée prédéterminée le signal de sortie du premier inverseur (61), et des portes NON-ET et NON-OU (70-5, 70-6) pour recevoir les signaux de sortie des moyens de génération d'ondes carrées (70-1) et des moyens de retard (70-2 à 70-4).

5. Multivibrateur selon la revendication 4,
dans lequel
les moyens de retard (70-2 à 70-4) comprennent un nombre impair d'inverseurs.

6. Multivibrateur selon la revendication 4 ou la revendication 5,
dans lequel
les moyens de génération d'ondes carrés (70-1) comprennent au moins un inverseur.

7. Multivibrateur selon l'une quelconque des revendications précédentes,
dans lequel
les moyens de commutation (60) comprennent un certain nombre de portes de transmission (60A-2 à 60B-2) branchées en série les unes aux autres et constituées chacune d'un transistor NMOS et d'un transistor PMOS.
